# EUROPEAN PATENT APPLICATION

(11) **EP 2 372 757 A2**
(43) Date of publication of application: **05.10.2011**
(21) Application number: 11250368.5
(22) Date of filing: 24.03.2011
(51) Int. Cl.: H01L 23/373, H01L 23/473

(54) **Integral cold plate and honeycomb facesheet assembly**

(30) Priority: 29.03.2010 US 748549
(71) Applicant: Hamilton Sundstrand Corporation, Windsor Locks, CT 06096-1010 (US)
(72) Inventor: Zaffetti, Mark A., Suffield Connecticut 06078 (US); Taddey, Edmund P., West Springfield Massachusetts 01089 (US)
(74) Representative: Tomlinson, Kerry John

(57) **Abstract**

A cold plate assembly (20) includes a face sheet assembly (22A) with an integral cold plate (26A) and a structure (S) mounted to the face sheet assembly. The face sheet assembly (22A) comprises: a first end sheet (40); a first parting sheet (42) brazed to said first end sheet (40); a fluid path B closure bar (46) brazed to said first parting sheet (42); a fluid path B fin structure (44) brazed to said first parting sheet (42); a middle parting sheet (48) brazed to said fluid path B fin structure (44) and said fluid path B closure bar (46); a fluid path A closure bar (52) brazed to said middle parting sheet (48); a fluid path A fin structure (50) brazed to said middle parting sheet (48); and a second parting sheet (54) brazed to said fluid path A fin structure (50), said fluid path A closure bar (52) and a first face sheet (24A).

## Description

### BACKGROUND

The present disclosure relates to a heat transfer device, and more particularly to a cold plate assembly.

Operation of high speed electronic components such as microprocessors, graphics processors and other modules produces heat. The heat may need to be removed for efficient operation. Heat removal provides, for example, lower operating temperatures, higher operating speeds, greater computing power and higher reliability.

Cold plates are liquid cooled structures which provide a heat transfer function for components mounted thereto.

### SUMMARY

A cold plate assembly according to an exemplary aspect of the present disclosure includes a face sheet assembly with an integral cold plate and a structure mounted to the face sheet assembly.

### BRIEF DESCRIPTION OF THE DRAWINGS

Various features will become apparent to those skilled in the art from the following detailed description of the disclosed non-limiting embodiment. The drawings that accompany the detailed description can be briefly described as follows:
Figure 1 is a general exploded view of a cold plate assembly;
Figure 2 is a perspective view of the cold plate assembly of Figure 1;
Figure 3 is a general exploded view of a cold plate assembly with exploded views of a first face sheet assembly and a second face sheet assembly;
Figure 4 is a general exploded view of a RELATED ART cold plate assembly with a separate self contained cold plate; and
Figure 5 is a general schematic view of a cold plate assembly attached to a structure.

### DETAILED DESCRIPTION

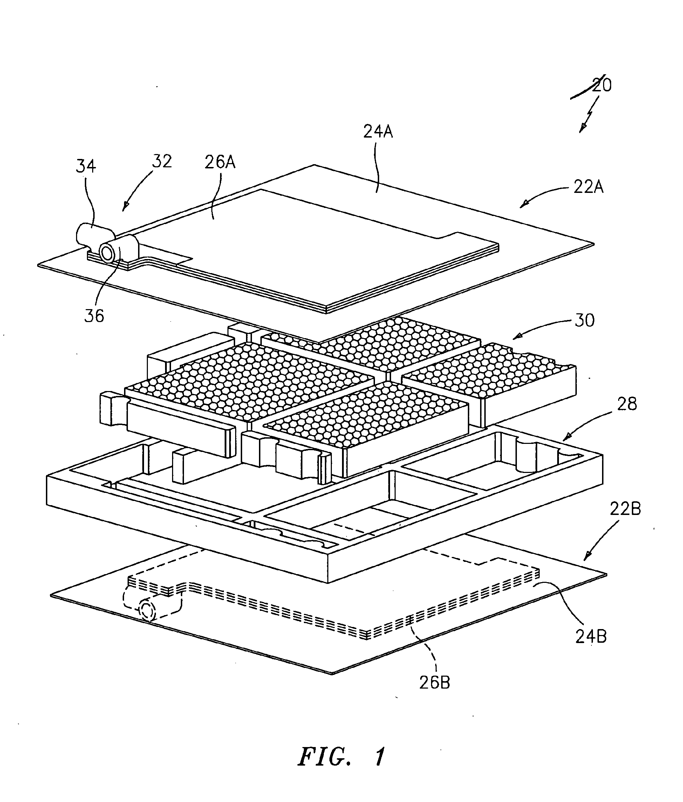

Figure 1 schematically illustrates a cold plate assembly 20. The cold plate assembly 20 generally includes a first face sheet assembly 22A that has a face sheet 24A with an integral cold plate 26A and a second face sheet assembly 22B that has a face sheet 24B with an integral cold plate 26B. The first face sheet assembly 22A and the second face sheet assembly 22B sandwich a structure S such as a frame 28 and a honeycomb core 30 typically through an adhesive. It should be understood that either or both of face sheets 24A, 24B may be a portion of any structure inclusive of an avionics component itself.

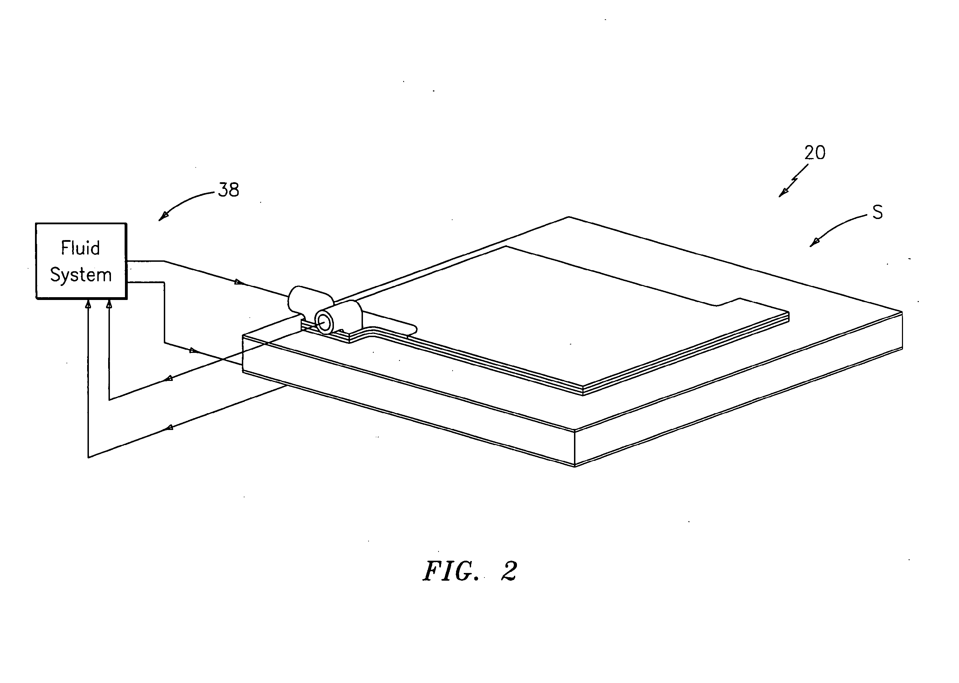

A header assembly 32 with an inlet port 34 and an outlet port 36 communicates fluid through the cold plate assembly 20. The header assembly 32 communicates with a fluid system 38 as generally understood (illustrated schematically; Figure 2).

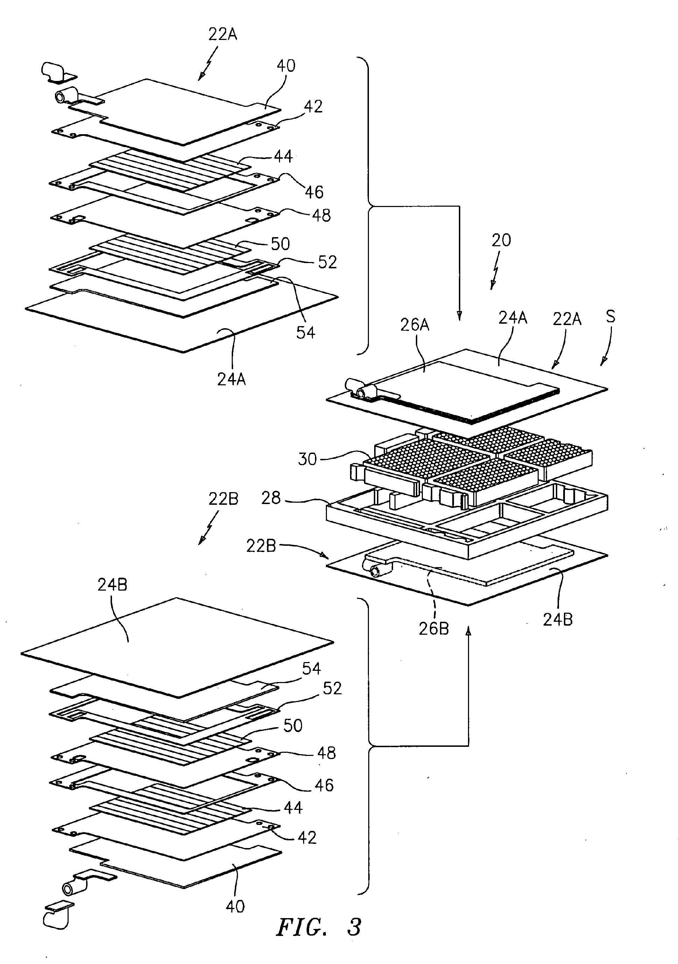

Referring to Figure 3, the first face sheet assembly 22A generally includes a first end sheet 40, a first parting sheet 42, a fluid path B closure bar 46, a fluid path B fin structure 44 (illustrated schematically), a middle parting sheet 48, a fluid path A closure bar 52, a fluid path A fin structure 50, (illustrated schematically), a second parting sheet 54 and the face sheet 24A.

In one non-limiting embodiment, the first end sheet 40 may be manufactured of 3004 Aluminum with a nominal thickness of 0.04 inches (1 mm), the first parting sheet 42 may be manufactured of a braze material, such as CT-23, or a Multiclad alloy with a nominal thickness of 0.016 inches (0.4 mm), the fluid path B closure bar 46 may be manufactured of 6951 Aluminum with a nominal thickness of 0.05 inches (1.3 mm), the fluid path B fin structure 44 may be manufactured of 6951 Aluminum with a nominal thickness of 0.005 inches (0.13 mm), the middle parting sheet 48 may be manufactured of a braze material, such as CT-23, or a Multiclad alloy with a nominal thickness of 0.016 inches (0.4 mm), the fluid path A closure bar 52 may be manufactured of 6951 Aluminum with a nominal thickness of 0.05 inches (1.3 mm), the fluid path A fin structure 50 may be manufactured of 6951 Aluminum with a nominal thickness of 0.005 inches (0.13 mm) and the second parting sheet 54 may be manufactured of a braze material, such as CT-23, or a Multiclad alloy with a nominal thickness of 0.016 inches (0.4 mm). It should be understood that various materials and nominal thickness may alternatively be utilized.

The parting sheets 42, 48 and 54 may include a braze alloy that melts during a brazing process that forms an integral assembly between the sheets 40-54. It should be understood that other bonding or assembly methods may alternatively or additionally be utilized. The sheets 40-54 may be brazed to the face sheet 24A as a unit to form the first face sheet assembly 22A, however, it should be understood that other bonding or assembly methods may alternatively or additionally be utilized.

Generally, the assembly is brazed together such that: the first end sheet 40 is brazed to the first parting sheet 42; the first parting sheet 42 is brazed to the first end sheet 40 and the path B closure bar 46 and the fluid path B fin structure 44; the fluid path B closure bar 46 is brazed to the first parting sheet 42 and the middle parting sheet 48; the fluid path B fin structure 44 is brazed to the first parting sheet 42 and the middle parting sheet 48; the middle parting sheet 48 is brazed to the fluid path B fin structure 44 and to the fluid path B closure bar 46 and to the fluid path A fin structure 50 and to the fluid path A closure bar 52; the fluid path A closure bar 52 is brazed to the middle parting sheet 48 and to the second parting sheet 54; the fluid path A fin structure 50 is brazed to the middle parting sheet 48 and to the second parting sheet 54; and the second parting sheet 54 is brazed to the fluid path A fin structure 50 and to the fluid path A closure bar 52 and to the first face sheet 24A.

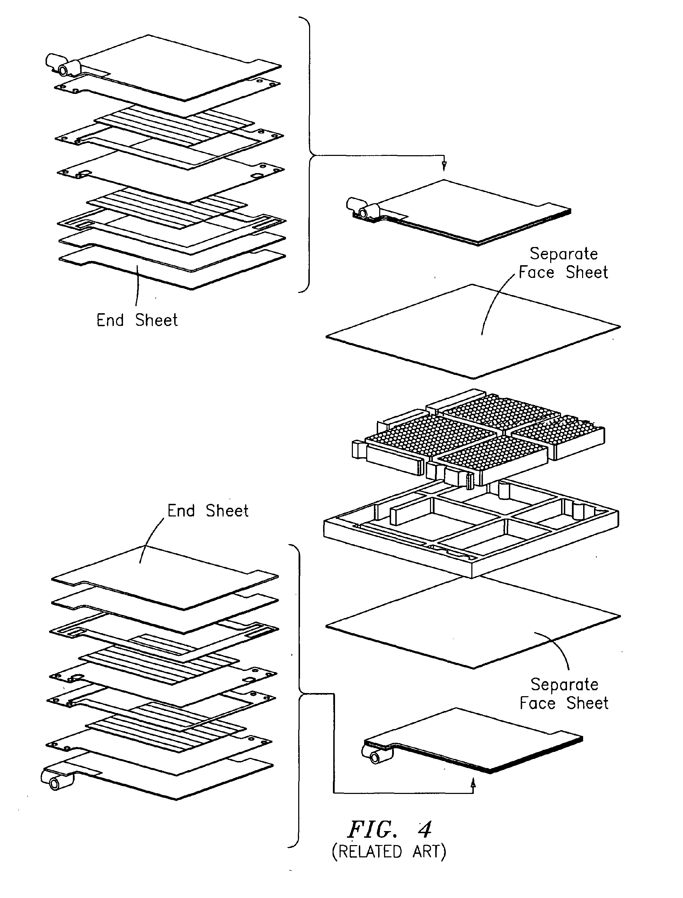

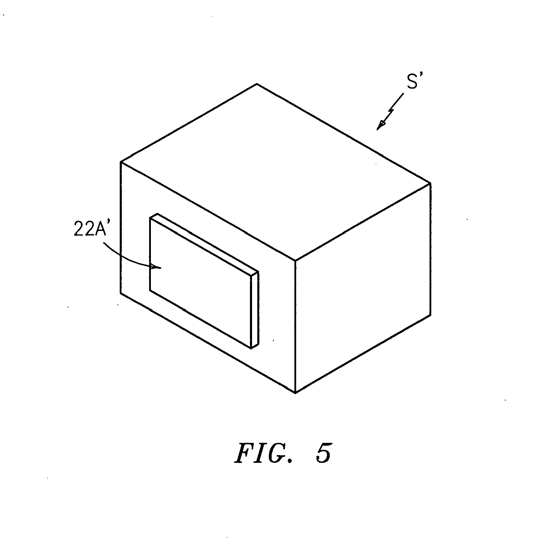

The cold plate 26A is integral to the first face sheet assembly 22A so as to eliminate one end sheet from what would conventionally be a separate self-contained cold plate (RELATED ART; Figure 4). That is, cold plate 26A eliminates one end sheet which is now replaced by the respective face sheet 24A. Thus when the structure S is fabricated, the face sheets 24A, 24B already include the integral cold plate 26A, 26B. It should be understood that only one or more cold plate assemblies 20 may be utilized. For example, one of the face sheet assemblies 22A, 22B need not actually include the respective integral cold plate 26A, 26B such that the face sheet assembly 22A is on only one side of the structure S or the face sheet assembly 22A' forms one face of another structure S' (Figure 5). Furthermore, it should be understood that although a support panel is the example structure utilized to provide for the integral cold plate 26A, 26B any heat transfer device or structure inclusive of the electronic components themselves may alternatively benefit herefrom.

The cold plate assembly 20 is formed with a reduced total part count through elimination of parts. Mounting hardware and/or structural adhesive for the cold plate 26A, 26B is eliminated. Weight, costs and additional processing steps are also thereby reduced as no mounting features need be machined or otherwise formed. Furthermore, a more structurally sound cold plate assembly 20 results.

It should be understood that like reference numerals identify corresponding or similar elements throughout the several drawings. It should also be understood that although a particular component arrangement is disclosed in the illustrated embodiment, other arrangements will benefit herefrom.

Although particular step sequences are shown, described, and claimed, it should be understood that steps may be performed in any order, separated or combined unless otherwise indicated and will still benefit from the present disclosure.

The foregoing description is exemplary rather than defined by the limitations within. Various non-limiting embodiments are disclosed herein, however, one of ordinary skill in the art would recognize that various modifications and variations in light of the above teachings will fall within the scope of the appended claims. It is therefore to be understood that within the scope of the appended claims, the disclosure may be practiced other than as specifically described. For that reason the appended claims should be studied to determine true scope and content.

## Claims

1. A cold plate assembly (20) comprising:
a face sheet assembly (22A) with an integral cold plate (26A).

2. The cold plate assembly as recited in claim 1, wherein said face sheet assembly includes a face sheet (24A) brazed to a parting sheet (54) of said integral cold plate.

3. The cold plate assembly as recited in claim 2, wherein said face sheet is larger than said integral cold plate.

4. The cold plate assembly as recited in claim 1, 2 or 3, wherein said face sheet assembly comprises:
a first end sheet (40);
a first parting sheet (42) brazed to said first end sheet;
a fluid path B closure bar (46) brazed to said first parting sheet;
a fluid path B fin structure (44) brazed to said first parting sheet;
a middle parting sheet (48) brazed to said fluid path B fin structure and said fluid path B closure bar;
a fluid path A closure bar (52) brazed to said middle parting sheet;
a fluid path A fin structure (50) brazed to said middle parting sheet; and
a second parting sheet (54) brazed to said fluid path A fin structure, said fluid path A closure bar and a first face sheet (24A).

5. The cold plate assembly as received in any preceding claim, further comprising:
a structure (S) mounted to said face sheet assembly.

6. The cold plate assembly as recited in claim 5, wherein said structure comprises a core (30) within a frame (28), preferably wherein the core is a honeycomb core.

7. The cold plate assembly as recited in claim 5 or 6, further comprising a second face sheet assembly (22B) with a second integral cold plate (26B), said second face sheet assembly mounted to said structure.

8. The cold plate assembly as recited in claim 7, wherein said second face sheet assembly includes a second face sheet (24A) that is larger than a parting sheet (54) of said second integral cold plate.

9. The cold plate assembly as recited in claim 7 or 8, wherein said second face sheet assembly and said first face sheet assembly sandwich said structure.

10. The cold plate assembly as recited in claim 7, 8 or 9, wherein said second face sheet assembly comprises:
a second end sheet (40);
a second parting sheet (42) brazed to said second end sheet;
a fluid path A closure bar (46) brazed to said second parting sheet;
a fluid path A fin structure (44) brazed to said second parting sheet;
a middle parting sheet (48) brazed to said fluid path A fin structure and said fluid path A closure bar;
a fluid path B closure bar (52) brazed to said middle parting sheet;
a fluid path B fin structure (50) brazed to said middle parting sheet; and
a first parting sheet brazed (54) to said fluid path B fin structure, said fluid path B closure bar and a face sheet (24B).

11. The cold plate assembly as recited in any preceding claim, wherein said first parting sheet, said middle parting sheet and said second parting sheet are manufactured of a braze alloy.

12. The cold plate assembly as recited in claim 11, wherein said braze alloy melts during a brazing process to form an integral structure.
